(19) **Europäisches Patentamt**

**European Patent Office**

**Office européen des brevets**

(11) **EP 1 276 324 B1**

(12) **EUROPEAN PATENT SPECIFICATION**

(45) Date of publication and mention
of the grant of the patent:
**04.10.2006 Bulletin 2006/40**

(51) Int Cl.:
*H04N 7/24* (2006.01)          *H03M 7/30* (2006.01)

(21) Application number: **01460047.2**

(22) Date of filing: **13.07.2001**

(54) **Method for compressing a hierarchical tree, corresponding signal and method for decoding a signal**

Verfahren zur Komprimierung einer Baumhierarchie, zugehöriges Signal und Verfahren zur Dekodierung eines Signals

Méthode de compression d'une structure arborescente hiérarchique, signal correspondant et méthode de décodage de signal

(84) Designated Contracting States:
**AT BE CH CY DE DK ES FI FR GB GR IE IT LI LU MC NL PT SE TR**

(43) Date of publication of application:
**15.01.2003 Bulletin 2003/03**

(73) Proprietors:
- **FRANCE TELECOM**
  **75015 Paris (FR)**
- **Groupe des Ecoles de Telecommunications-Etablissement ENST de Bretagne**
  **75634 Paris (FR)**
- **Expway**
  **51100 Reims (FR)**

(72) Inventors:
- **Concolato, Cyril**
  **94250 Gentilly (FR)**
- **Seyrat, Claude**
  **75005 Paris (FR)**
- **Pau, Grégoire**
  **75015 Paris (FR)**
- **Thienot, Cédric**
  **75011 Paris (FR)**
- **Cotarmanac'h, Alexandre**
  **3500 Rennes (FR)**

(74) Representative: **Vidon, Patrice**
**Cabinet Vidon**
**16 B, rue Jouanet - B.P. 90333**
**Technopole Atalante**
**35703 Rennes Cedex 7 (FR)**

(56) References cited:
WO-A-02/21848          WO-A-97/34240
WO-A-02/063776

- LIEFKE H ET AL: "XMILL: AN EFFICIENT COMPRESSOR FOR XML DATA" SIGMOD RECORD, ASSOCIATION FOR COMPUTING MACHINERY, NEW YORK, US, vol. 29, no. 2, June 2000 (2000-06), pages 153-164, XP001002286
- NACK F ET AL: "EVERYTHING YOU WANTED TO KNOW ABOUT MPEG-7: PART 2" IEEE MULTIMEDIA, IEEE COMPUTER SOCIETY, US, vol. 6, no. 4, October 1999 (1999-10), pages 64-73, XP000880605 ISSN: 1070-986X
- "TEXT OF ISO/IEC FCD 15938-1 INFORMATION TECHNOLOGY - MULTIMEDIA CONTENT DESCRIPTION INTERFACE - PART 1 SYSTEMS" ISO/IEC JTC1/SC29/WG11 MPEG01/N4001, XX, XX, March 2001 (2001-03), pages 1-2,I-V,6-58, XP001001465
- CHENEY J: "Compressing XML with multiplexed hierarchical PPM models" PROCEEDINGS DCC 2001. DATA COMPRESSION CONFERENCE, PROCEEDINGS DCC 2001. DATA COMPRESSION CONFERENCE, SNOWBIRD, UT, USA, 27-29 MARCH 2001, pages 163-172, XP002187036 2001, Los Alamitos, CA, USA, IEEE Comput. Soc, USA ISBN: 0-7695-1031-0
- WIRELESS APPLICATION PROTOCOL FORUM: "WAP Binary XML Content Format" WAP BINARY XML CONTENT FORMAT DOCUMENT ID WAP-192-WBXML-20000515 VERSION 1.3, XX, XX, 15 May 2000 (2000-05-15), pages 1-25, XP002168490

**Description**

The field of the invention is that of the compression of data. More precisely, the invention regards the compression of XML-based document ("eXtended Markup Language").

The invention has applications, in particular, but not only, in the following fields :

- multimedia applications ;
- indexation tools ;
- meta-data manipulation tools ;
- the MPEG-7 specification (see notably NACK et al. "Everything you wanted to know about MPEG-7: Part 2" IEEE Multimedia, IEEE Computer Society, US, vol. 6, no.4, October 1999, pages 64-73).
- SMIL;
- TV Anytime;
- the third generation of radiocommunications (3GPP).

Compression techniques of the prior art for XML have several drawbacks. In particular, they do not support at the same time fast access to data, high compression ratios and progressive construction of the document. In other words, most of the time, when one of the above mentioned feature is supported, all other features are missing.

One of the compression techniques of the prior art is known as BiM (Binary MPEG) and is notably described in Text of ISO/IEC FCD 15938-1 Information Technology Multimedia Content Description Interface - Part1 Systems" "ISO/IEC" JTC1/SC 29/WG11 "MPEG" 01/N4001, March 2001. Such a technique provides a method for compressing a XML document by binarising the structure of the document, that it to say the nodes of a tree structure associated to the XML document. Hence, the compression ratio achieved by implementing the BiM technique is very poor, although the BiM technique allows a fast access to data, progressive construction of the document and skippability.

Liefke et al. in " XMILL : An efficient compressor for XML Data", (Sigmod Record, Association for Computing Machinery, New York, US , vol. 29 , no. 2, June 2000, pages 153-164) have also described a method for compressing data in a XML tree. A drawback of this technique is that it does not allow to identify a sub-tree, to allocate a specific compression encoding technique to a data type of the identified sub-tree, and to implement this compression encoding technique only for the leaves of the sub-tree whose data is of the type associated compression encoding technique.

It is an aim of the invention to compensate for the drawbacks of the techniques of the prior art.

More precisely, the invention aims at providing an efficient compression technique for XML-based documents.

The invention also aims at providing a compression technique for XML which provides skippability, high compression ratios and progressive construction of the document.

The invention also aims at compressing efficiently MPEG-7 descriptors.

Another aim of the invention is to implement a method for compressing an XML document which enhances greatly the compression ratio provided by a technique of the BiM type, but which provides the same functionalities as that provided by BiM.

The above mentioned aims of the invention, as well as other aims of the invention which will appear later on, are achieved, according to the invention, by means of a method for compressing a hierarchical tree describing a multimedia signal, said tree comprising nodes and leaves, which can be associated to contents of at least two distinct types, wherein said method implements a content compression for at least some of said leaves by means of at least two compression encoding techniques, each of said techniques being selectively associated to at least one of said content types.

According to a preferred embodiment of the invention, such a method comprises a step of identifying at least one sub-tree and a step of allocating one of said compression encoding techniques to said sub-tree.

Advantageously, such a method comprises a step of implementing said compression encoding technique allocated to said sub-tree only for the leaves of said sub-tree whose content is of the type associated to said compression encoding technique, and the other leaves of said sub-tree do not undergo any compression encoding.

According to an advantageous feature of the invention, such a method implements a parametrical description of said compression encoding techniques.

Preferentially, such a method also comprises a step of compressing the structure of said tree.

Advantageously, said tree is of the BiM (Binary MPEG) type according to the MPEG7 standard.

Preferentially one of said compression encoding techniques implements linear quantization.

Advantageously, one of said compression encoding techniques implements a statistical compression algorithm.

Preferentially, said algorithm is of the GZip type.

Advantageously, said algorithm is simultaneously implemented for a set of data corresponding to the content of at least two leaves.

Preferentially, said tree represents the structure of an XML (Extended markup language) type document.

The invention also regards a method for decoding a multimedia signal compressed according to the above-mentioned method for compressing a hierarchical tree.

Advantageously, such a method implements a step of refreshing a present decoding context according to encoding context information conveyed by said signal.

Preferentially, said present context defines at least one content type, said method comprising a step of implementing a compression decoding technique associated to said content type for the leaves having a content of said content type.

The invention also regards a signal generated by the above-mentioned method for compressing a hierarchical tree.

Other features and assets of the invention will appear more clearly in light of the following description, given as a mere illustrative but non restrictive example, and of the following figures :

- figure 1 illustrates the concept of coding context;
- figure 2 describes the structure of an element as coded according to the BiM technique ;

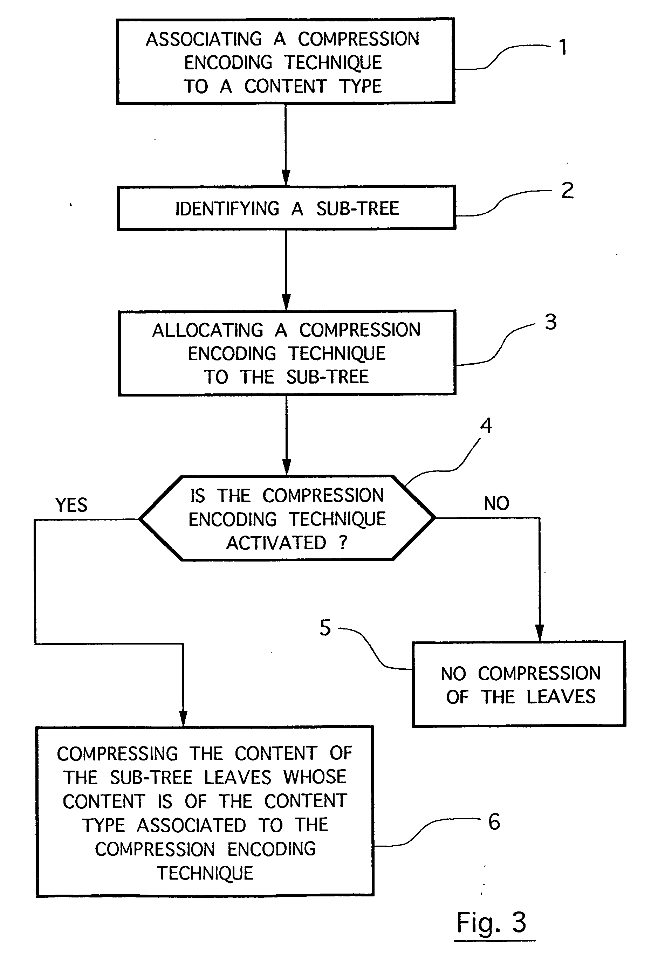

- figure 3 illustrates some of the steps implemented according to the invention for compressing the content of the leaves of a hierarchical tree.

Before describing in details how to implement the invention, we first recall the main features of the compression technique of the prior art, known as the BiM technique.

To ease the understanding of the document, some references are gathered in annex 9 and referred to throughout the document.

All the annexes provided with the present document are part of the present

description of the invention.

## 1. Prior art

### Introduction

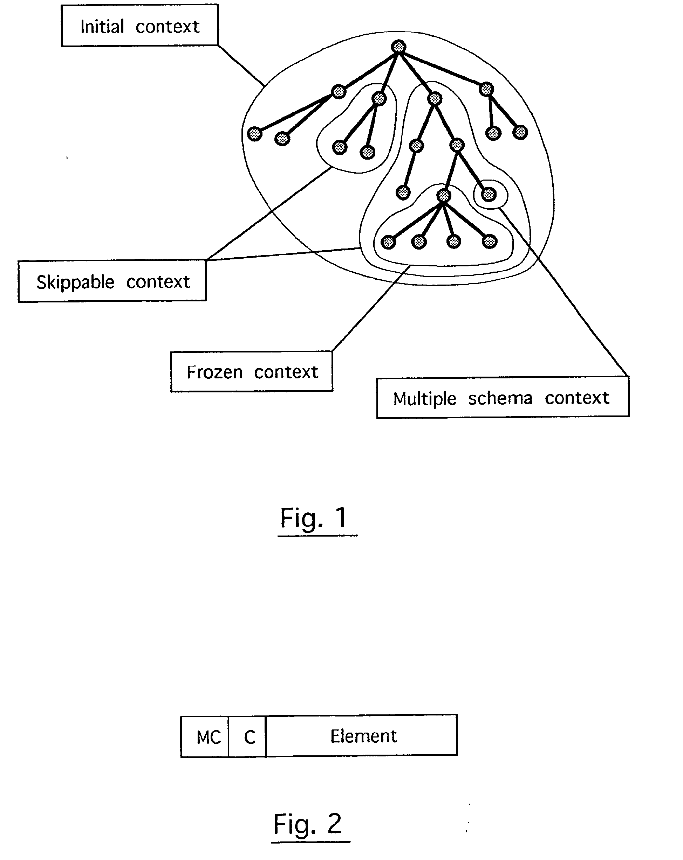

A coding context, illustrated in figure 1, is a set of decoding information, needed while decoding the bitstream. A coding context is applicable to the whole sub-tree of the node where it is defined. At every nodes of the tree, the coding context can be modified ; leading to the creation of a new coding context, applicable to the corresponding sub-tree.

A context can carry several information which edict features applicable to the concerned sub-tree. Currently, in the BiM sub-tree coding format [1], these features are skippability of a sub-tree/context and multiple schema encoding of a sub-tree/context (in order to provide the backward and forward compatibility feature).At last, the context mechanism can be disabled in every sub-tree in order to save bandwidth ; this is the context frozen mode.

The coding context mechanism provides maximum flexibility in every sub-tree of a document tree and allows extensible features to be plugged into the BiM encoding mechanism. We know presents the current context mechanism used in BiM.

### Current coding context mechanism

#### *Definitions*

#### CodingContext

A *codingContext* is a set of information, the contextual information, needed by the decoder to decode the bitstream. A *codingContext* is applicable to the node where it has been defined, and the whole sub-tree corresponding to this node.

The current *codingContext*, (i.e. the context applicable at a specified node of a description) can be modified within the document (that is to say, a modification of its underlying set of information). Each modification of a *codingContext* leads to the creation a of new *codingContext*, which will carry the modified set of information. All *codingContexts* are expected to be stacked, in order to get them back, when the decoder has finished decoding a sub-tree corresponding context.

### Decoder

The BiM *decoder* is composed of two decoders :

- the context decoder ; this decoder is dedicated to decode the contextual information. As stated before, the contextual information is not part of the description. This is a set of information which carry some external features, backward and forward compatibility, fast skipping...
- the element decoder ; this decoder, the BiM regular one [1] is dedicated to decode the element information.

## Chunks

Each element of a description is coded as the 3-plet illustrated in figure 2, where the header part is constituted of two chunks, whom sizes can be nil:

- MC is the metacontext chunk ;
- C is the context chunk ;
- Element is the element chunk, which is the regular element coding chunk, see [1].

The MC metacontext chunk contains the information needed by the decoder to decode the following C chunk. That is to say that the MC chunk is the context chunk of the C context chunk.

The C context chunk contains the information able to change the current coding context set of information, and needed by the decoder to decode the following element chunk. That is to say that the C chunk is the context chunk of the element chunk.

## Set of information

The current BiM coding context carries a set of information, the contextual information, which can be divided in the two following main classes :

- the metacontext section ; if the information contained in this section, influence only the context decoding process
- the context section ; if the information contained in this section, influence only the element decoding process

The current set of information is the following set of variables :

| Class | Variable | Value | Description |
|---|---|---|---|
| Mctacontext | freezing_state | boolean | false: The context can be changed within this sub-tree. true : The context cannot be changed anymore in this sub-tree. |
| Context | allows_skip | (mandatory, optional, forbidden) | Is skipping feature mandatory, optional or forbidden in this context ? |
| | schema_mode | (mono, multi) | Is the current element coded with multiple schemas ? |
| | allows_partial_instantiation | boolean | Is partial instantiation allowed in this context ? |
| | allows_subtyping | boolean | Is subtyping allowed in this context ? |

The classes defined are exactly coding the chunks described above (the MC metacontext chunk and the C context chunk).

### *Metacontext chunk*

### Definition

The MC metacontext chunk, which size can be null, contains information to know if the decoder has to read the next C context chunk, described in the following section.

**Variables involved**

| Variable | Value | Description |
|---|---|---|
| freezing_state | boolean | false: The context can be changed within this sub-tree. The MC chunk will be coded into the bitstream.<br>true : The context cannot be changed anymore in this sub-tree. The MC chunk won't be coded into the bitstream. |

**Default values**

The default value of freezing_state is false ; that is to say that, by default, the root context can be dynamically changed.

**Propagation rules**

At the creation of a new context:

- the freezing_state value is set to the freezing_state value of its father's context

**Dynamic modification rules**

At each node of a description and in order to create a new context:

- freezing_state value can be switched from the value false to the value true

**Decoding rules**

If the freezing_state value is true, the MC metacontext chunk (and the upcoming C context chunk) is not coded into the bitstream. Otherwise, the MC metacontext chunk part of the header is coded as follows:

| MC 0 { | # of bits | Mnemonic |
|---|---|---|
| freeze_type | 1-3 | vlclbf |
| } | | |

The context_chunk is a local variable, initialised at false.

| freeze type | Implication |
|---|---|
| 110 | context_chunk = true and freezing_state = true |
| 10 | context_chunk = true |
| 111 | context_chunk = false and freezing_state = true |
| 0 | context_chunk = false |

As stated in the previous section, the modification of the variables of the current context implies the creation of a new context.

**Influence on the context decoding process**

If the context_chunk value is true, the decoder has to read the following C context chunk.

*Context chunk*

**Definition**

The C context chunk, which size can be null, contains a set of information able to dynamically change the current context variables. These variables are called codingProperties because they influence the BiM element decoding process.

**CodingProperties involved**

| codingProperty | Value | Description |
|---|---|---|
| allows_skip | (mandatory, optional, forbidden) | Is skipping feature mandatory, optional or forbidden in this context ? |
| schema_mode | (mono, multi) | Is the current element coded with multiple schemas ? |
| allows_partial_instantiation | boolean | Is partial instantiation allowed in this context ? |
| allows_subtyping | boolean | Is subtyping allowed in this context ? |

**Default values**

The allows_skip variable is initialized at the beginning of the bitstream by the first two bits of the special 4 bits bitfield, as defined in the FCD Systems document [1].

The allows_partial_instantiation variable is initialized at the beginning of the bitstream by the third two bits of the special 4 bits bitfield.

The allows_subtyping variable is initialized at the beginning of the bitstream by the fourth two bits of the special 4 bits bitfield.

The default value of schema_mode is mono ; that is to say that, by default, the root sub-tree/context is encoded with one schema.

**Propagation rules**

At the creation of a new context:

- allows_skip value is set to the allows_skip value of its father's context
- allows_partial_instantiation value is set to the value of its father's context
- allows_subtyping value is set to the value of its father's context
- schema_mode value is set to its default value

**Dynamic modification rules**

At each node of a description and in order to create a new context:

- allows_skip can be dynamically modified
- allows_partial_instantiation cannot be dynamically modified
- allows_subtyping cannot be dynamically modified
- schema_mode can be dynamically modified

**Decoding rules**

The C Context chunk is present only if the MC metacontext chunk is already present and its previous local variable context_chunk is true.

The dynamic modification of the current context is described with an XML element which is encoded with the BiM regular encoding scheme. The global element modifyContext from the BiM schema is used. The http://www.mpeg7.org/2001/BiMCoding coding schema is described in annex 1.

The C context chunk has to be decoded with the BiM regular scheme, with the above schema.

As stated before, the modification of the current codingProperties in the context implies the creation of a new context. Therefore, the presence of the C context chunk, implies the creation of a new context, which will carry the modified codingProperties.

If the allowsSkip element is instantiated within the modifyContext element, then the value of allows_skip will be updated in the new context.

If the schema_mode element is instantiated within the modifyContext element, then the value of schema_mode will be updated in the new context.

**Influence on the element decoding process**

The allows_skip and schema_mode values influence the element decoding process, when dealing with the skipping feature. This behavior is described in [1].

The schema_mode value influences the element decoding process, in order to know if the element is coded with only one schema or several ones. This mechanism is described in [1].

The allows_partial_instantiation value influences the element decoding process, by adding one special type partiallyInstantiated type to the possible subtypes of the clement. See [1].

The allows_subtyping value influences the element decoding process, and allows an element or an attribute to have different possible types, in case of element polymorphism (with the xsi:type attribute) or union. See [1].

## 2. Description of the invention

### 2.1. Extension of the context mechanism to provide a framework for leaf compression

The invention proposes to extend the current BiM context mechanism in order to support a new and interesting feature : the use of local compressors to compress leaves of a document, in order to reduce the size of the resulting bitstream.

This section describes how to extend the current BiM context mechanism to support the use of local compressors. This is typically a new set of variables, codingProperties, linked with specific semantic, propagation and coding rules. Therefore, this new set of codingProperties will extend the current context chunk.

### *Introduction*

In a sub-tree, all the instances of one or several specified simple type can be compressed with one or several specified compressor. This basically defines a mapping between a compressor and one or several simple types. Moreover:

- in some cases, a compressor can need some external parameters
- a mapping can be activated/deactivated, in order to use a compressor in some sub-trees but not in another ones

At last, in order to be activated/deactivated, a mapping should be referencable and therefore, must have an unique identifier in a context.

Therefore, each context can carry zero, one or several codecTypeMapper ; where a codecTypeMapper is a 4-plet, consisting of an identifier, one or several simple types, a codec, optional external codec parameters and an activation state.

### Definitions

### CodecTypeMapper

A *codecTypeMapper* is a 4-plet, consisting of:

- an identifier, used as an unique reference key in a sub-tree/context
- one or several simple types, for which the mapping is applicable
- a codec
- optional external codec parameters (depends of the codec)
- an activation state

### Identifier

The identifier is an unique number which identify a mapping within a context in an unambiguous way. The BiM coding schema restricts the maximal number of codecTypeMappers in a context to 32.

### Simple type

All the simple types defined in a schema could be *a priori* encoded by every codec but, each codec can restrict this choice. For instance, a linear quantizer, as defined hereafter in the document, can only be used with numerical simple types.

A simple type is identified by its name, and the by the URL of the schema its belongs. XML Schema prefixes should be used, in order to point to the correct schema. The BiM coding schema defines a special type to encode this couple ; this type should be encoded as couple of integers ; the first integer is restricted to the current number of schemas known (this piece of information can be fetched in the DecoderConfig part [1]) and the second integer is restricted to the number of global simple types present in the corresponding schema.

### Codec

A *codec*, standing for compressor/decompressor, is a module which takes input bits, and writes output bits. It can need some optional external parameters.

A codec is identified by a name, among the names of non-abstract codecs defined in the BiM coding schema. The current BiM coding schema, defined in a section above, doesn't define any non-abstracts codecs, but §2.2 of the present document does.

### Activation state

The activation state is a boolean flag.

### Semantic rules

### CodecTypeMapper

Each context:

- can carry zero, one or several codecTypeMappers
- can define one or several codecTypeMappers
- can activate or deactivate one or several existing codecTypeMappers If a codecTypeMapper is defined in a context, it remains in all its subcontexts.

An existing codecTypeMapper, within a context, cannot be deleted nor modified (except its activation state).

### Identifier

The identifier of a mapping must be unique among all the codecTypeMappers of a context.

### Simple type

When you associate in a codecTypeMapper one or several simple types and a codec, the codec will encode/decode the simple types themselves and all the simple types which derived from them.

In a context, there must be at most one simple type than can be applicable with a codec.

### Codec

There are two types of codecs : memoryless codecs and contextual codecs.

A memoryless codec is a module which encodes always the same input bytes into the same bytes out ; independently of the history of the codec. A typical memoryless codec is a linear quantifier. The BiM leaf compression (see §2.2 of the present document) describes such a codec.

A contextual codec is a module which uses the previous bytes fed in it, (thus changing the context of the codec).

Such a codec doesn't generate the same output bytes for the same input bytes it receives. A typically contextual codec is a Zip-like local codec, one is described in §2.2 of the present document.

A memoryless codec doesn't induce any problem in the current context architecture but a contextual codec does, in case of skippable sub-tree. In such cases, a contextual codec is reset, in order not to confuse the decoder, when this former has skipped the sub-tree.

### Activation state

In every sub-tree/context, a codecTypeMapper can be activated or deactivated.

This mechanism allows to define a codecTypeMapper in a higher level of the document tree, and activate it only in the sub-trees it is used, without redefining the codecTypeMapper.

### A new codingProperty : codecTypeMapper

In this part, we add a new codingProperty to the previous set of variables of the context section, described before. This new codingProperty is named codecTypeMapper and is a list of the previous codecTypeMapper described in the previous section.

### New codingProperty involved

The context carries a list of codecTypeMapper :

| CodingProperties | Value | Description |
|---|---|---|
| codecTypeMapper[i].identifier | int | Numerical identifier to reference a codingProperty in a context in a unambiguous way. |
| codecTypeMapper[i].simple_type[j] | int ; int | List of 2-plet (Numerical index of a schema, numerical index of a simple type in the current schema) |
| codecTypeMapper[i].codec | int | Numerical index of a codec in the current coding context scheme |
| codecTypeMapper[i].codec_parameter s | | Optional external codec parameters. |
| codecTypeMapper[i].activation_state | boolean | State of activation of a codingProperty. |

### New default values

By default, there is no codecTypeMapper in a sub-tree/context.

If a codecTypeMapper is defined within a context, its identifier, codec and simple_type value must be defined. If not specified, the state of activation of a newly defined codecTypeMapper is set to true by default ; that is to say that a newly defined codecTypeMapper is activated by default.

### New propagation rules

**Rule 1:** At the creation of a new context, the codecTypeMapper list is the copy of its father's context:

- the identifier value is copied
- the simple_type value is copied
- the codec value is copied according to the rule 2
- the codec_parameters value are copied
- the activation_state is copied

**Rule 2:** The codec value is copied and if :

- the father's codec codingProperty[i].codec is a contextual codec
- and if the current context is skippable

Then,
the decoder is expected to create a new instance of the codec by copying the instance of the father's codec (not only its value), and resetting it.

For instance, a ZLib codec would be copied and re-initialized when entering a skippable node.

**New dynamic modification rules**

The list of codecTypeMapper can be dynamically modified, within the description :

- a new codecTypeMapper can be defined
- the activation_state of an existing (then referencable) codecTypeMapper can be dynamically modified

An existing codecTypeMapper cannot be deleted and its members cannot be dynamically modified (except its activation_state).

**New decoding rules**

The same previous rules apply to the C context chunk decoding, but the new schema, described in annex 2, should be used, in order to add the new codecTypeMapper dynamic modification functionalities.

**Informative part**

***Examples***

The example, illustrated in annex 3, presents the definition of one activated linear quantifier (see §2.2 of the present document) in a description.

The example, illustrated in annex 4, presents the definition of one deactivated linear quantifier in a description.

**2.2 BiM Leaf compression**

We now present the mechanism implemented by the invention to encode data with different codecs. More precisely, we now illustrate two examples, one where a linear quantization codec is used to compress, for example, floating point values, and the other where a gzip coedc is used to compress, for example, string values.

Such a mechanism is closely related to the coding context and allows the use of several other types of codecs. Moreover, it allows to deal properly with coding context features, for instance skippable subtrees. Finally it allows re-use of codecs in different coding contexts.

**Introduction**

The BiM sub-tree coding [1] doesn't compress the data leaves of a description. Currently, leaf values are encoded with respect of their types (IEEE 754 floats and doubles, UTF strings...).

In many cases, it could be useful to use some classical compression techniques like linear quantization or statistical compression to improve the compression ratio of BiM without losing its main features (streamline parsing, fast skipping feature, typed decoding).

This document presents how data leaves compression of a document can be done within the context coding mechanism described in §2.1, in order to achieve better compression ratios.

**2.2.1. Linear quantization**

***Definition***

Linear quantization is an usual and lossy way to reduce the size of encoded numbers in the bitstream, when the source of the information is known and therefore, when losses can be controlled.

As an example, the envelope of a sampled audio signal is often known with a precise bitsize quantization, and this technique could be fruitfully used for coding MPEG-7 audio descriptions.

If is a real number, it can be encoded with $v_q$ with *nbits* bits where :

$$v_q = \frac{v - v_{min}}{v_{max} - v_{min}}(2^{nbits} - 1)$$

where :

- $v_q$ is the quantized, encoded value of $v$
- *nbits* is the precision required in bits
- $v_{min}$ is the minimal inclusive value that $v$ can reach
- $v_{max}$ is the maximal inclusive value that $v$ can reach

And the decoded value from $v$ is $v$ , with :

$$\bar{v} = v_{min} + v_q \frac{v_{max} - v_{min}}{2^{nbits} - 1}$$

where :

- $v$ is the decoded, approximated value of $v$

### *Integration with the context mechanism : the LinearQuantizerCodec*

Linear quantization can be used as a codec, as defined in the coding context mechanism described in §2.1 of the present document. With this mechanism, linear quantization can be applied on numerical data leaves, of a desired simple type, in any sub-tree of a description.

Used like this, the coding context mechanism, associated with the linear quantization codec, is acting as the QuantizationParameter node, used in MPEG-4 BIFS [3].

### Restriction on applicable simple types

According to the definition of a codec in §2.1 of the present document, this codec is a memoryless codec, which can be applied on every atomic and non-atomic simple numerical types ; whose XML Schema primitive type is float, double or decimal.

### Codec external parameters

The linear quantizer codec needs the following 3 mandatory parameters :

- bitSize ; the *nbits* variable described above
- minInclusive ; the $v_{min}$ variable described above
- maxInclusive ; the $v_{max}$ variable described above

### Schema definition of the codec

The linear quantization codec is a new codec of type LinearQuantizerCodecType, based on the abstract CodecType type (see §2.1) and defined by the schema given in annex 5, in the coding context namespace URL xmlns: cc=http://www.mpeg7.org/2001/BiMCoding.

### Encoding (informative)

A numerical data leaf of value $v$ is encoded with the unsigned integer $v_q$ on *nbits* bits where :

$$v_q = \frac{v - v_{min}}{v_{max} - v_{min}}(2^{nbits} - 1)$$

**Decoding**

The unsigned integer $v_q$, coded on *nbits* bits, should be decoded as $v$ where :

$$\bar{v} = v_{\min} + v_q \frac{v_{\max} - v_{\min}}{2^{nbits} - 1}$$

**Example (informative)**

The example illustrated in annex 6 presents the definition of a linear quantizer in a description.

**2.2.2. Statistical compression**

Classical statistical lossless compression algorithms can be used as codecs, as defined in the coding context mechanism (see §2.1). With this mechanism, data leaves, of a desired simple type, can be compressed efficiently in any sub-tree of a description.
This codec is useful for significantly reducing the size of the bitstream, especially when the description contains many repetitive or similar strings.

***Definition***

Classical lossless statistical compression algorithms (like Zip or GZip) can be used in BiM to compress any leaves of a description.
But, in most cases, when data leaves are short strings which contain fewer than 10 characters, this leads to poor performances because usual statistical compression algorithms requires a larger lookahead buffer.
In order to achieve optimal compression ratio, the leaves of a document have to be buffered into a small buffer before being compressed. The following section defines such a buffered statistical coder, relying on an underlying lossless statistical compression algorithm.

**Definitions of a buffered statistical coder**

A buffered statistical coder relies on an underlying statistical coder which should contain the generic following primitives methods :

- initialize_stream() ; which initializes a compressing or a decompressing stream
- reset_model() ; which resets the current statistical model of the coder
- feed_input_bytes() ; which takes input decompressed bytes and put them in the compressing stream
- flush_output_bytes() ; which flushes the compressing stream by compressing the input bytes already processed and by emitting the corresponding compressed output bytes
- decompress_input_bytes(); which takes a specified amount of input compressed bytes and decodes them by emitting the corresponding decompressed output bytes

A buffered codec has a bufferSize bytes length, byte array buffer FIFO structure.
From the encoder side, the bufferSize value indicates how many input bytes the encoder can process before flushing. From the decoder side, this is the minimal buffer size in bytes, needed to decode the bitstream, through the underlying statistical coder API.
The buffer has also a fillingLevel variable, which contains the actual filling level, in bytes, of the buffer.

**Using the ZLib API as a statistical coder**

The ZLib public library API [4], used in the GZip compression scheme, provides an efficient and useful API for using statistical compression on document leaves.
The ZLib API fulfils the previous generic methods, with the following mapping :

- initialize_stream() can be mapped with the ZLib's inflateInit() or deflateInit() functions, with the Z_DEFAULT_COMPRESSION efficiency value parameter.
- reset_model() can be mapped with an ZLib's inflateEnd() or a deflateEnd() call and a following initialize_stream () call.

- feed_input_bytes() can be mapped with the ZLib's deflate() method with the Z_NO_FLUSH parameter.
- flush_output_bytes() can be mapped with the ZLib's deflate() method with the Z_SYNC_FLUSH parameter.
- decompress_input_bytes() can be mapped with the ZLib's inflate() method.

The ZLib buffered codec should be initialized with the Z_DEFAULT_COMPRESSION efficiency value, as defined in [4], which provides a good tradeoff between memory footprint requirements and compression efficiency.

### Integration with the context mechanism : the ZLibCodec

This section describes the integration of the previously buffered statistical coder defined, relying on the ZLib API, within the coding context mechanism.

### Restriction on applicable simple types

According to the definition of a codec in §2.1, this codec is a contextual codec, which can be applied on every atomic and non-atomic string types. The ZLibCodec is relying on the underlying primitive encoding of leaves of a document, as described in [1]. For instance, int leaves are encoded with a 32 bits unsigned integer, string with a UTF-8 encoding, float and double are encoded with the IEEE 754 format, ... Therefore, the ZLibCodec will compress the encoded leaf

### Codec external parameters

The buffered ZLib codec doesn't need any external parameters, as the efficiency of the underlying ZLib is set at Z_DEFAULT_COMPRESSION and as the bufferSize parameter is not needed from the decoder side.

### Schema definition of the codec

The ZLib codec is a new codec of type ZLibCodecType, based on the abstract CodecType (see §2.1) type and defined by the schema illustrated in annex 7, in the coding context namespace.

### Encoding (informative)

At the activation/instantiation of the codec :

- the FIFO buffer structure is supposed to be clear, its fillingLevel is set to 0
- the global variable referencable_chunk is initialized to null

The referencable_chunk should contain a referencable chunk of bits, which must be hold by the encoder, because its value will be known later during the encoding process. The signaling function signal_reference_chunk_known() could be called when this chunk is known.

The size, in bytes, of every non-nil chunk should be write before the chunk itself, during the flush_output_bytes () call, with the standard unsigned infinite integer 4+1 coding, as defined in [1].

An input leaf is the encoded value of a textual leaf, with respect of its primitive type. The length of the leaf, in bytes, is given by the field leaf.length. For instance [1], a string leaf is an UTF-8 code, preceded by the size in bytes of the string (coded with the infinite integer coding [1]) ; a double leaf is the 64-bits value of the corresponding IEEE 754 standard...

The following encode_leaf function is able to encode a leaf in a chunk of output bytes :

```
chunk encode_leaf(chunk leaf) {

    while (leaf is not empty) {

        if (fillingLevel + leaf.length < bufferSize) {

            feed_input_bytes(leaf,leaf.length)

            fillingLevel = fillingLevel + leaf.length

            if (referencable_chunk is null) {

                referencable_chunk = new chunk

                return referencable_chunk

            } else {

                return nil_size_chunk

            }

        } else {

            remaining_bytes = bufferSize – fillingLevel – leaf.length

            feed_input_bytes(leaf,remaining_bytes)

            referencable_chunk = flush_output_bytes()

            signal_reference_chunk_known()

            fillingLevel = 0

            leaf = leaf.remove_beginning_bytes(remaining_bytes)

            referencable_chunk = null

        }

    }

}
```

**Decoding**

Let string_fifo be a string FIFO.
The following methods get() and put() respectively take an element out resp. put an element from resp in the FIFO.
The method is Empty() signals whether the Fifo is empty
Let sub be the function that takes a substring.
Let concat be the concatenation function
Let getData() the function that returns the char[] holding de-gzip data from a leaf .
Let split(char[], char sep, Fifo, char[] remainder) be the method that splits an array of characters at each separator 'sep' and stores the separated string elements into the Fifo and returns the remainder (i.e. the last chunk that has no 'sep' to finish it)

```
split(char [] data, char sep, FIFO string_fifo,char[] remainder)
{
    if (data==null) return;
    int BEGIN=0;
    for (int I=0;I<data.length;I++)
    {
        if (data[I]==sep)
        {
            char[] str= concat(remainder, sub(data,BEGIN,I));
            put(string_fifo, str);
            BEGIN=I+1;
        }
    }
    if (BEGIN!=data.length)
    {
        //there's a remainder.
        remainder = sub(data,BEGIN,data.length);
    }


}
String decode()
{
    if (isEmpty(string_fifo)
    {
        data = getData();
        split(data,0x00,string_fifo,remainder);
    }
    return get(string_fifo);
}
```

At initialization, string_fifo is empty.
At the activation/instantiation of the codec :

-    the FIFO structure is supposed to be clear, its numberOfLeaves is set to 0

- the variable first_chunk is set to true

Let the separator byte be 0x00.
The following decode_leaf function is able to decode a compressed leaf from the bitstream :

```
string decode_leaf() {

    if (numberOfLeaves == 0) {

        read_and_decompressed_byte()

        numberOfLeaves = count_number_of_leave_in_buffer()

    } else {


    }

}
```

Decoding is defined by :

    1. If the FIFO is empty :

        a. decode the coded data,
        b. stack in a FIFO all elements separated by 0x00
        c. if the last character is not 0x00 store the unfinished string temporarily.
        d. if "last_element" is not empty, insert it at the beginning of the first element in FIFO
        e. put the unfinished string of this round in last_element.
        f. remove and return the first element.

    2. If the FIFO is not empty, then remove and return the first element. It is equivalent to say : "the FIFO is not empty" and to say "there is no encoded data in a the current leaf."

**Example (informative)**

The description given in annex 8 is an example of the usage of the ZLibCodecType codec, mapped with the string and the anyURI types.

*Results (informative)*

The following figures show the performances of using the ZLibCodec so as to compress textual leaves of descriptions (those derived from the string and the anyURI XML Schema primitive types). A buffer of bufferSize = 256 bytes was used during the encoding process.
The files used were provided by the MPEG-7 MDS sub-group.

| Filename | Original size (bytes) | BiM size (bytes) | BiM with the ZLibcodec size (bytes) | Zipped file size (bytes) |
|---|---|---|---|---|
| mdsExamplesClause11-12.xml | 160658 | 22512 | 10602 | 17019 |
| mdsExamplesClause13-15.xml | 81133 | 11627 | 8538 | 9698 |
| mdsExamplesClause17.xml | 142426 | 57583 | 22489 | 21444 |
| mdsExamplesClause4-7.xml | 37208 | 6536 | 3748 | 7623 |
| mdsExamplesClause8-10.xml | 8179 | 2081 | 1389 | 2416 |

We now quickly describe the steps implemented according to the invention for compressing the content of the leaves of a hierarchical tree.

Step 1 consists in associating a compression encoding technique to a content type. For example, linear quantization can be associated to floating point values.

In step 2, a sub-tree is identified within the hierarchical tree corresponding to the structure of the considered XML document.

Step 3 consists in allocating a compression encoding technique to the identified sub-tree.

Step 4 then consists in checking whether the codec implementing the compression encoding technique is or not activated. If no, no compression (5) of the leaves of the sub-tree is achieved.

If yes, the invention implements (6) compression of the content of the sub-tree leaves whose content is of the content type associated (1) to the compression encoding technique.

### ANNEX 1

```
<schema targetNamespace="http://www.mpeg7.org/2001/BiMCoding"
    xmlns:cc="http://www.mpeg7.org/2001/BiMCoding"
    xmlns="http://www.w3.org/2000/10/XMLSchema">

    <element name="modifyContext">
        <complexType>
            <sequence>
                <element name="allowsSkip" minOccurs="0">
                    <simpleType>
                        <restriction base="string">
                            <enumeration value="mandatory"/>
                            <enumeration value="optional"/>
                            <enumeration value="forbidden"/>
                        </restriction>
                    </simpleType>
                </element>

                <element name="schemaMode" minOccurs="0">
                    <simpleType>
                        <restriction base="string">
                            <enumeration value="mono"/>
                            <enumeration value="multi"/>
                        </restriction>
                    </simpleType>
                </element>
            </sequence>
        </complexType>
    </element>
</schema>
```

**ANNEX 2**

```
<schema targetNamespace="http://www.mpeg7.org/2001/BiMCoding"
xmlns:cc=" http://www.mpeg7.org/2001/BiMCoding"
xmlns="http://www.w3.org/2000/10/XMLSchema"
>
        <element name="context">
            <complexType>
                <sequence>
                    <element name="allowsSkip" minOccurs="0">
                        <simpleType>
                            <restriction base="string">
                                <enumeration
value="mandatory"/>
                                <enumeration
value="optional"/>
                                <enumeration
value="forbidden"/>
                            </restriction>
                        </simpleType>
                    </element>

                    <element name="schemaMode" minOccurs="0">
                        <simpleType>
                            <restriction base="string">
                                <enumeration value="mono"/>
                                <enumeration value="multi"/>
                            </restriction>
                        </simpleType>
                    </element>

                    <element name="codecTypeMappers"
minOccurs="0">
                        <complexType>
                            <sequence>
                                <element
name="codecTypeMapper"

        type="cc:codecTypeMapper"
                                            maxOccurs="unbounded"/>
                            </sequence>
                        </complexType>
                    </element>

            </sequence>
</complexType>
        </element>

        <!-- a type can be pointed with the help of a XML Schema
prefix, in order
            to know the schema it is belonging to
    -->
        <simpleType name="coupleSchemaTypeType">
            <restriction base="string"/>
        </simpleType>
```

```
<!-- restriction of 32 maximal codecTypeMappers in a context
-->
        <simpleType name="codecIDType">
            <restriction base="integer">
                <minInclusive="0"/>
                <maxInclusive="31"/>
            </restriction>
        </simpleType>




        <complexType name="codecTypeMapperType">
            <sequence>
                <element name="type" type="coupleSchemaTypeType"
maxOccurs="unbounded"/>
                <element name="codec" type="cc:codecType"/>
            </sequence>
            <attribute name="id" use="required"
type="codecIDType"/>
            <attribute name="state">
                <simpleType>
                    <restriction base="string">
                        <enumeration value="activated"/>
                        <enumeration value="deactivated"/>
                    </restriction>
                </simpleType>
            </attribute>
        </complexType>

        <complexType name="codecType" abstract="true"/>

    </schema>
```

**ANNEX 3**

```
<Example xmlns:cc="http://www.mpeg7.org/2001/BiMCoding">
    <AudioEnvelope>
        <cc:modifyContext>
            <codingProperties>
                <codingProperty id="1">
                    <type>audioFloat</type>
                    <codec xsi:type="LinearQuantifierType">
                        <bitSize>8</bitSize>
                        <minInclusive>-1.0</minInclusive>
                        <maxInclusive>1.0</maxInclusive>
                    </codec>
                </codingProperty>
            </codingProperties>
        </cc:modifyContext>
        <Values>
            <Raw>
                -0.25411 0.88541 0.2141946 0.3652541 -0.148941 0.8814
0.145544 -0.847
            </Raw>
        </Values>
    </AudioEnvelope>
</Example>
```

**ANNEX 4**

```
<Example xmlns:cc="http://www.mpeg7.org/2001/BiMCoding">
    <AudioEnvelope>
        <cc:modifyContext>
            <codingProperties>
                <codingProperty id="1" state="deactivated">
                    <type>audioFloat</type>
                    <codec xsi:type="LinearQuantifierType">
                        <bitSize>8</bitSize>
                        <minInclusive>-1.0</minInclusive>
                        <maxInclusive>1.0</maxInclusive>
                    </codec>
                </codingProperty>
            </codingProperties>
        </cc:modifyContext>
        <Values>
            <Raw> <!-- quantization here -->
                <cc:modifyContext>
                    <codingProperties>
                        <codingProperty id="1" state="activated"/>
                    </codingProperties>
                </cc:modifyContext>
                -0.25411  0.88541  0.2141946  0.3652541  -0.148941  0.8814
0.145544 -0.847
            </Raw>
            <Variance> > <!-- but no quantization here -->
                0.1777441 0.2094511 0.349411 0.548444 -0.445445 -0.3654847
0.9541
            </Variance>
```

```
                    </Values>
                  </AudioEnvelope>
                    </Example>
```

**ANNEX 5**

```
<complexType name="LinearQuantizerCodecType">
      <complexContent>
            <extension base="cc:CodecType">
                  <element name="bitSize">
                        <simpleType>
                              <restriction base="int">
                                    <minInclusive value="1"/>
                                    <maxInclusive value="32"/>
                              </restriction>
                        </simpleType>
                  </element>
                  <element name="minInclusive" value="float"/>
                  <element name="maxInclusive" value="float"/>
            </extension>
      </complexContent>
</complexType>
```

**ANNEX 6**

```
<Example xmlns:cc="http://www.mpeg7.org/2001/BiMCoding">
    <AudioEnvelope>
        <cc:modifyContext>
            <codecTypeMappers>
                <codecTypeMapper id="1" state="deactivated">
                    <type>audioFloat</type>
                    <codec xsi:type="LinearQuantizerCodecType">
                        <bitSize>8</bitSize>
                        <minInclusive>-1.0</minInclusive>
                        <maxInclusive>1.0</maxInclusive>
                    </codec>
                </codecTypeMapper>
            </codecTypeMappers>
        </cc:modifyContext>
        <Values>
            <Raw> <!-- quantization here -->
                <cc:modifyContext>
                    <codecTypeMappers>
                        <codecTypeMapper id="1" state="activated"/>
                    </codecTypeMappers>
                </cc:modifyContext>
                -0.25411 0.88541 0.2141946 0.3652541 -0.148941 0.8814 0.145544 -0.847
            </Raw>
            <Variance> > <!-- but no quantization here -->
                0.1777441 0.2094511 0.349411 0.548444 -0.445445 -0.3654847 0.9541
            </Variance>
        </Values>
    </AudioEnvelope>
</Example>
```

**ANNEX 7**

```
<complexType name="ZLibCodecType">
    <complexContent>
        <extension base="cc:CodecType"/>
    </complexContent>
</complexType>
```

**ANNEX 8**

```xml
<MdsExampleTest xmlns="http://www.mpeg7.org/2001/MPEG-7_Schema"
    xmlns:cc="http://www.mpeg7.org/2001/BiMCoding"
    <cc:modifyContext>
        <codecTypeMappers>
            <codecTypeMapper id="1">
                <type>string</type>
                <type>anyURI</type>
                <codec xsi:type="ZLibCodecType"/>
            </codecTypeMapper>
        </codecTypeMappers>
    </cc:modifyContext>


    <!--    the termId attributes, Name elements and Definitions elements
            will be catched by the ZLibCodecType -->


    <ClassificationScheme uri="urn:mpeg:MPEG7AudioDomainCS" domain="/..">
        <Term termId="1">
            <Name xml:lang="en">Source</Name>
            <Definition xml:lang="en">Type of audio source</Definition>
            <Term termId="1.1">
                <Name xml:lang="en">Synthetic</Name>
            </Term>
            <Term termId="1.2">
                <Name xml:lang="en">Natural</Name>
            </Term>
        </Term>
        <Term termId="2">
            <Name xml:lang="en">Acquisition</Name>
```

```
<Definition xml:lang="en">Type of Content</Definition>

<Term termId="2.1">

    <Name xml:lang="en">Music</Name>

</Term>

<Term termId="2.2">

    <Name xml:lang="en">Speech</Name>

</Term>

<Term termId="2.3">

    <Name xml:lang="en">Mixed</Name>

</Term>

<Term termId="2.4">

    <Name xml:lang="en">Multi-track</Name>

<Term>

</Term>

...
```

## ANNEX 9

**References**

1 - MPEG-7 Systems FCD, N4001, MPEG Singapore meeting, March 2001.
3 - ISO/IEC 14496-1, MPEG-4 Systems, N3850.
4 - The ZLib API, http://www.gzip.org/zlib/, RFC 1950, RFC 1951, RFC 1952 available at http://www.cis.ohio-state.edu/cgi-bin/rfc/rfc1950.html

## Claims

1. Method for compressing a hierarchical tree describing a multimedia signal, said tree comprising nodes and leaves, which can be associated to data of at least two distinct natures, called data types, wherein said method implements a data compression for at least some of said leaves, and wherein said method comprises:

   - a step of identifying (2) at least one sub-tree;
   - a step of allocating (3) one compression encoding technique to said sub-tree(s) for at least one data type ;
   - and a step of implementing (6) said compression encoding technique allocated to said sub-tree only for the leaves of said sub-tree whose data is of the type associated to said compression encoding technique, while the other leaves of said sub-tree do not undergo any compression encoding.

2. Method according to claim 1, implementing a parametrical description of said compression encoding techniques.

3. Method according to any of claims 1 and 2, also comprising a step of compressing the structure of said tree.

**4.** Method according to any of claims 1 to 3, wherein said tree is of the BiM (Binary MPEG) type according to the MPEG7 standard.

**5.** Method according to claim 4, wherein said data types are simple types according to the MPEG7 standard.

**6.** Method according to any of claims 1 to 5, wherein one of said compression encoding techniques implements linear quantization.

**7.** Method according to any of claims 1 to 6, wherein one of said compression encoding techniques implements a statistical compression algorithm.

**8.** Method according to claim 7, wherein said algorithm is of the GZip type.

**9.** Method according to any of claims 7 and 8, wherein said algorithm is simultaneously implemented for a set of data corresponding to the data of at least two leaves.

**10.** Method according to any of claims 1 to 9, wherein said tree represents the structure of an XML (Extended markup language) type document.

**11.** Method according to any of claims 1 to 10, also comprising a step of associating at least one coding context to said sub-tree, said coding context comprising pieces of information allowing to skip said sub-tree while decoding said hierarchical tree.

**12.** Method according to claim 11, wherein said pieces of information comprise :

- a piece of information indicating the used compression encoding technique ; and/or
- a piece of information indicating if the corresponding sub-tree has been compressed ; and/or
- a piece of information indicating if the corresponding sub-tree is skippable; and/or
- a piece of information indicating that at least, one parameter of the used compression encoding technique has been modified.

**13.** Method for decoding a multimedia signal compressed according to the method of any of claims 1 to 12.

**14.** Method according to claim 13, implementing a step of refreshing a present decoding context according to encoding context information conveyed by said signal.

**15.** Method according to claim 14, wherein said present context defines at least one data type, said method comprising a step of implementing a compression decoding technique associated to said data type for the leaves comprising data of said data type.

**16.** Signal representative of a hierarchical tree compressed according to the method of any of claims 1 to 12, said tree comprising nodes and leaves, which can be associated to data of at least two distinct natures, called data types, said tree also comprising at least one sub-tree to which has been allocated one compression encoding technique for at least one data type, wherein said signal comprises at least one field containing:

- the leaves of said sub-tree whose data is of the data type associated to said compression encoding technique and which have undergone said compression encoding;
- the other leaves of said sub-tree whose data is not of the data type associated to said compression encoding technique and which have not undergone said compression encoding.

**17.** Signal according to claim 16, wherein said signal also comprises:

- at least one field indicating said compression encoding technique allocated to said sub-tree(s) for said at least one data type;
- at least one field indicating said at least one data type associated to said compression encoding technique for said sub-tree(s).

18. Signal according to claim 17, wherein said signal also comprises at least one field indicating at least one parameter of said compression encoding technique allocated to said sub-tree(s) for at least one of said data type(s).

**Patentansprüche**

1. Verfahren zum Komprimieren eines ein Multimedia-Signal beschreibenden hierarchischen Baums, wobei der Baum Knoten und Blätter aufweist, welche mit Daten zumindest zweier verschiedener Arten, genannt Datentypen, verknüpft werden können,
wobei das Verfahren eine Datenkompression zumindest einiger der Blätter durchführt, und wobei das Verfahren umfasst:

einen Schritt des Identifizierens (2) zumindest eines Unterbaums;
einen Schritt des Zuordnens (3) einer Kompressionskodiertechnik zu dem Unterbaum (den Unterbäumen) für zumindest einen Datentyp;
und einen Schritt des Durchführens (6) der dem Unterbaum zugeordneten Kompressionskodiertechnik, nur für diejenigen Blätter des Unterbaumes deren Daten von dem mit der Kompressionskodiertechnik verknüpften Typ sind, während die anderen Blätter des Unterbaums keiner Kompressionskodierung unterzogen werden.

2. Verfahren nach Anspruch 1,
das ein parametrisches Beschreiben der Kompressionskodiertechniken durchführt.

3. Verfahren nach einem der Ansprüche 1 und 2,
umfassend auch einen Schritt des Komprimierens der Struktur des Baums.

4. Verfahren nach einem der Ansprüche 1 bis 3,
wobei der Baum von dem BiM (Binären MPEG) Typ gemäß dem MPEG7-Standard ist.

5. Verfahren nach Anspruch 4,
wobei die Datentypen einfache Typen gemäß dem MPEG7-Standard sind.

6. Verfahren nach einem der Ansprüche 1 bis 5,
wobei eine der Kompressionskodiertechniken eine lineare Quantisierung durchführt.

7. Verfahren nach einem der Ansprüche 1 bis 6,
wobei eine der Kompressionskodiertechniken einen statistischen Kompressionsalgorithmus durchführt.

8. Verfahren nach Anspruch 7,
wobei der Algorithmus von dem GZip-Typ ist.

9. Verfahren nach einem der Ansprüche 7 und 8,
wobei der Algorithmus gleichzeitig für eine Gruppe von Daten durchgeführt wird, die den Daten zumindest zweier Blätter entsprechen.

10. Verfahren nach einem der Ansprüche 1 bis 9,
wobei der Baum die Struktur eines Dokuments vom XML (Extended markup language) -Typ repräsentiert.

11. Verfahren nach einem der Ansprüche 1 bis 10,
auch umfassend einen Schritt des Verknüpfens zumindest eines Kodierkontexts mit dem Unterbaum, wobei der Kodierkontext Informationsteile aufweist, die es erlauben, den Unterbaum während des Dekodierens des hierarchischen Baums zu überspringen.

12. Verfahren nach Anspruch 11,
wobei die Informationsteile umfassen:

einen Informationsteil, der die verwendete Kompressionskodiertechnik angibt; und/oder

einen Informationsteil, der angibt, ob der entsprechende Unterbaum komprimiert worden ist; und/oder
einen Informationsteil, der angibt, ob der entsprechende Unterbaum überspringbar ist; und/oder
einen Informationsteil, der angibt, dass zumindest ein Parameter der verwendeten Kompressionskodiertechnik modifiziert worden ist.

13. Verfahren zum Dekodieren eines Multimediasignals, das gemäß dem Verfahren nach einem der Ansprüche 1 bis 12 komprimiert ist.

14. Verfahren nach Anspruch 13, das einen Schritt des Auffrischens eines vorliegenden Dekodierungskontexts entsprechend einer durch das Signal übermittelten Kodierkontextinformation durchführt.

15. Verfahren nach Anspruch 14, wobei der vorliegende Kontext zumindest einen Datentyp definiert, wobei das Verfahren einen Schritt des Durchführens einer mit dem Datentyp verknüpften Kompressionskodiertechnik umfasst, für die Blätter, die Daten des Datentyps umfassen.

16. Signal repräsentativ für einen hierarchischen Baum, der gemäß dem Verfahren nach einem der Ansprüche 1 bis 12 komprimiert ist,
wobei der Baum Knoten und Blätter aufweist, die mit Daten zumindest zweier verschiedener Arten, genannt Datentyp, verknüpft werden können,
wobei der Baum auch zumindest einen Unterbaum aufweist, dem eine Kompressionskodiertechnik für zumindest einen Datentyp zugeordnet ist,
wobei das Signal zumindest ein Feld aufweist, welches enthält:

die Blätter des Unterbaums, deren Daten von dem Datentyp sind, der mit der Kompressionskodiertechnik verknüpft ist, und die dem Kompressionskodieren unterzogen wurden;
die anderen Blätter der Unterbaums, deren Daten nicht von dem Datentyp sind, der mit der Kompressionskodiertechnik verknüpft ist, und die nicht dem Kompressionskodieren unterzogen wurden.

17. Signal nach Anspruch 16,
wobei das Signal auch umfasst:

- zumindest ein Feld, das die Kompressionskodiertechnik angibt, welche dem Unterbaum (den Unterbäumen) für den zumindest einen Datentyp zugeordnet ist;
- zumindest ein Feld, das den zumindest einen Datentyp angibt, welcher mit der Kompressionskodiertechnik für den Unterbaum (die Unterbäume) verknüpft ist.

18. Signal nach Anspruch 17,
wobei das Signal auch zumindest ein Feld aufweist, das zumindest einen Parameter der Kompressionskodiertechnik angibt, die dem Unterbaum (den Unterbäumen) für zumindest einen der Datentypen zugeordnet ist.

**Revendications**

1. Procédé de compression d'un arbre hiérarchique de description d'un signal multimédia, ledit arbre comprenant des noeuds et des feuilles,
lesdites feuilles pouvant être associées à des données d'au moins deux natures distinctes, dites types de données, **caractérisé en ce que** ledit procédé met en oeuvre une compression des données d'au moins certaines desdites feuilles, et comprend :

- une étape d'identification (2) d'au moins un sous-arbre ;
- une étape d'affectation (3) d'une technique de codage de compression d'au moins un type de données au(x) dit(s) sous-arbre(s) ; et
- une étape de mise en oeuvre (6) de ladite technique de codage de compression affectée audit sous-arbre uniquement pour les feuilles dudit sous-arbre dont les données sont d'un type de données associé à ladite technique de codage de compression, les autres feuilles dudit arbre ne subissant pas de codage de compression.

2. Procédé de compression selon la revendication 1, **caractérisé en ce qu'**il met en oeuvre une description paramétrique desdites techniques de codage de compression.

**3.** Procédé de compression selon l'une quelconque des revendications 1 et 2, **caractérisé en ce qu'**il comprend également une étape de compression de la structure dudit arbre.

**4.** Procédé de compression selon l'une quelconque des revendications 1 à 3, **caractérisé en ce que** ledit arbre est de type BiM (Binary MPEG) selon la norme MPEG7.

**5.** Procédé de compression selon la revendication 4, **caractérisé en ce que** lesdits types de données sont des types simples (« simple type ») selon la norme MPEG7.

**6.** Procédé de compression selon l'une quelconque des revendications 1 à 5, **caractérisé en ce qu'**une desdites techniques de codage de compression met en oeuvre une quantification linéaire.

**7.** Procédé de compression selon l'une quelconque des revendications 1 à 6, **caractérisé en ce qu'**une desdites techniques de codage de compression met en oeuvre un algorithme de compression statistique.

**8.** Procédé de compression selon la revendication 7, **caractérisé en ce que** ledit algorithme est de type GZip.

**9.** Procédé de compression selon l'une quelconque des revendications 7 et 8, **caractérisé en ce que** ledit algorithme est mis en oeuvre simultanément sur un ensemble de données correspondant aux données d'au moins deux feuilles.

**10.** Procédé de compression selon l'une quelconque des revendications 1 à 9, **caractérisé en ce que** ledit arbre est représentatif de la structure d'un document de type XML (« extended markup language »).

**11.** Procédé de compression selon l'une quelconque des revendications 1 à 10, **caractérisé en ce qu'**il comprend en outre une étape d'association d'au moins un contexte de codage audit sous-arbre, ledit contexte de codage comprenant des informations permettant de skipper ledit sous-arbre lors du décodage dudit arbre hiérarchique.

**12.** Procédé de compression selon la revendication 11, **caractérisé en ce que** lesdites informations comprennent :

- une information indiquant la technique de codage de compression utilisée ; et/ou
- une information indiquant si le sous-arbre correspondant a été compressé ; et/ou
- une information indiquant si le sous-arbre correspondant est skippable ; et/ou
- une information indiquant qu'au moins un paramètre de la technique de codage de compression utilisée a été modifié.

**13.** Procédé de décodage d'un signal multimédia compressé selon le procédé de compression de l'une quelconque des revendications 1 à 12.

**14.** Procédé de décodage selon la revendication 13, **caractérisé en ce qu'**il met en oeuvre une étape de rafraîchissement d'un contexte courant de décodage en fonction d'informations de contexte d'encodage véhiculées par ledit signal.

**15.** Procédé de décodage selon la revendication 14, **caractérisé en ce que** ledit contexte courant définit au moins un type de données, et **en ce qu'**il comprend une étape de mise en oeuvre d'une technique de décodage de compression associée audit type de données pour les feuilles ayant des données dudit type de données.

**16.** Signal représentatif d'un arbre hiérarchique compressé selon le procédé de compression de l'une quelconque des revendications 1 à 12,
ledit arbre comprenant des noeuds et des feuilles, lesdites feuilles pouvant être associées à des données d'au moins deux natures distinctes, dites types de données,
ledit arbre comprenant également au moins un sous-arbre auquel est affectée une technique de codage de compression d'au moins un type de données,
**caractérisé en ce que** ledit signal comprend au moins un champ comportant :

- les feuilles dudit sous-arbre dont les données sont du type de données associé à ladite technique de codage de compression, et ont subi ladite technique de codage de compression ;
- les autres feuilles dudit sous-arbre dont les données ne sont pas du type de données associé à ladite technique de codage de compression, et n'ont pas subi ladite technique de codage de compression.

**17.** Signal selon la revendication 16, **caractérisé en ce que** ledit signal comprend également :

- au moins un champ indiquant ladite technique de codage de compression d'au moins un desdits types de données affectée au(x)dit(s) sous-arbre(s) ;
- au moins un champ indiquant ledit au moins un type de données associé à ladite technique de codage de compression du ou desdits sous-arbre(s).

**18.** Signal selon la revendication 17, **caractérisé en ce que** ledit signal comprend également au moins un champ indiquant au moins un paramètre de ladite technique de codage de compression d'au moins un desdits type(s) de données affectée au(x)dit(s) sous-arbre(s).

Initial context

Skippable context

Frozen context

Multiple schema context

Fig. 1

| MC | C | Element |
|----|---|---------|

Fig. 2

ASSOCIATING A COMPRESSION
ENCODING TECHNIQUE
TO A CONTENT TYPE — 1

IDENTIFYING A SUB-TREE — 2

ALLOCATING A COMPRESSION
ENCODING TECHNIQUE
TO THE SUB-TREE — 3

4

YES     IS THE COMPRESSION
ENCODING TECHNIQUE
ACTIVATED ?     NO

5

NO COMPRESSION
OF THE LEAVES

COMPRESSING THE CONTENT OF
THE SUB-TREE LEAVES WHOSE
CONTENT IS OF THE CONTENT
TYPE ASSOCIATED TO THE — 6
COMPRESSION ENCODING
TECHNIQUE

Fig. 3